# EUROPEAN PATENT APPLICATION

(11) **EP 0 557 008 A2**
(43) Date of publication of application: **25.08.1993**
(21) Application number: 93300965.6
(22) Date of filing: 10.02.1993
(51) Int. Cl.: G06F 15/72

(54) **Apparatus and method for electronic impositioning**

(30) Priority: 17.02.1992 IL 100981
(71) Applicant: SCITEX CORPORATION LTD., Herzliya 46103 (IL)
(72) Inventor: Bieber, Avigdor, Ra'anana (IL); Wrobel, Victor, Hod Hasharon (IL); Barak, Paltiel, Givatayim (IL); Carlebach, Ephraim N., Ra'anana (IL); Braunold, Michael, Ra'anana (IL)
(74) Representative: Hillier, Peter

(57) **Abstract**

A method and apparatus for electronic impositioning is described. The apparatus includes a) apparatus for receiving a plurality of images of pages to be printed wherein each image occupies a corresponding printing rectangle of predetermined size, b) apparatus for associating with each image an imposition window of the size of the corresponding printing rectangle, c) apparatus for receiving a plurality of the imposition windows and for generating at least a portion of a flat template therefrom and d) apparatus for replacing each of the imposition windows with the appropriate one of the plurality of images, thereby to create at least a portion of an imposed flat.

## Description

### FIELD OF THE INVENTION

The present invention relates to imposition systems generally and to imposition systems for color separations in particular.

### BACKGROUND OF THE INVENTION

The production of a book or magazine involves a large number of processes. The processes may be grouped into five general categories: prepress, plate preparation, press set up or "make ready"; press control operations; and postpress operations.

In prepress, the principal processes are graphics, image and text editing and composition. In recent years, this area has undergone revolutionary changes through application of computer technology. State of the art systems for graphics and image editing and composition are known as Color Electronic Prepress Systems (CEPS), an example of which is the RESPONSE system manufactured by Scitex Corporation Ltd., Herzlia, Israel.

Systems for scanning, image processing and plotting include systems manufactured and sold by Scitex Corporation Ltd., such as, respectively, the systems sold under the trademarks Smart Scanner, Assembler and Raystar.

Plate preparation involves a technique known as imposition or signature assembly, which refers to the arrangement of pages on films used to produce a printing plate. A "signature" typically refers to the information on both sides of a printing plate. A "flat" typically refers to the information on one side of a printing plate.

The present state of the art in signature assembly is the use of large and expensive machinery requiring highly skilled operators. Presently available signature assembly machinery involves the following steps: exposure of each of a plurality of separations (such as Cyan, Magenta, Yellow and Black (CMYK)) for each of a plurality of pages to be arranged on a single plate; and subsequently, for each separation, such as C, feeding the exposed plurality of pages to an expose and repeat device such as the Misomex Master S Series, commercially available from Misomex North America Inc., Rosemont, Illinois. The expose and repeat device is operative to arrange the plurality of exposed C separations, corresponding to the plurality of pages to be arranged on a single plate, at precisely determined positions on a plate ready film and to reproduce the C separations at the precisely determined positions by a photographic process.

The C printing plate is produced by contact exposure of the plate ready film. The signature is proofed prior to exposure of the plate. The plate, once exposed, is often found to be imperfect and therefore generally requires quality inspection and defect repair processes. The plate preparation process is repeated in order to produce M, Y and K plates.

Various processes in the production of printed matter are discussed in the following publications, the disclosures of which are incorporated herein by reference:

Alfred Furler, Folding in Practice, in collaboration with STAHL GMBH & Co., 3rd Edition, Germany, 1983;

William Schreiber, Fundamentals of Electronic Imaging Systems, Springer-Verlag, New York, 1986;

R. K. Molla, Electronic Color Separation, RK Publications, 1988; and

Michael H. Brill (Ed.), Perceiving, measuring and Using Color, SPIE Proceedings, Vol. 1250, Billingham, Washington, USA, Feb. 1990;

Robert A. Ulicheney, Digital Halftoning and Physical Reconstruction Function, Ph.D. Thesis, Massachusetts Institute of Technology, MA, USA, June 1986; and

Raymond Blair and Charles Shapiro (Eds.), The Lithographer's Manual, GATF, USA, 1980.

Computer technology has also been proposed for use in facilitating certain stages of the imposition process as described in European Published Patent Application 0309196, published March 29, 1989, European Published Patent Application 0348908, published January 3, 1990 and in U.K. Patent 2128843, published on May 2, 1984. U.S. Patent 4,150,991 describes one type of optical imposition machine employing transparencies.

A procedure known as "electronic stripping" has been devised in order to improve the generation of plate ready films. Electronic stripping involves generating plate ready films directly on a large format exposure unit. Typically, pages are designed on any suitable system and are provided to an impositioning workstation, such as a MACINTOSH manufactured by Apple Computer Corporation of the U.S.A. The workstation creates an impositioned flat from the page information and provides the flat to the large format exposure unit.

The impositioning workstation typically includes impositioning software, such as IMPOSTRIP manufactured by Ultimate Technographics of Montreal, Canada and IMPOSITION PUBLISHER manufactured by Farrukh Systems of London, United Kingdom.

The impositioning software determines the proper orientation and location for each of the pages in a flat and determines which pages are associated with which flat.

The impositioning software typically receives pages defined in the POSTSCRIPT page description language defined by Adobe Systems of Mountainview, Ca, U.S.A. The software produces flats described in POSTSCRIPT.

However, since POSTSCRIPT is not the "native" page description language of a CEPS nor is it, necessarily, the native page description language of the exposure unit, the impositioning workstation cannot be used in conjunction with the CEPS without having to convert the pages produced by the CEPS to the POSTSCRIPT language. The native page description language of the RESPONSE system is the Line Work and Continuous Tone format.

### SUMMARY OF THE INVENTION

It is therefore an object of the present invention to provide a system which combines the operations of a CEPS and an impositioning system.

There is therefore provided, in accordance with an embodiment of the present invention, apparatus for electronic impositioning which includes a) apparatus for receiving a plurality of images of pages to be printed each image occupying a corresponding printing rectangle of predetermined size, b) apparatus for associating with each image an imposition window of the size of the corresponding printing rectangle, c) apparatus for receiving a plurality of the imposition windows and for generating at least a portion of a flat template therefrom and d) apparatus for replacing each of the imposition windows with the appropriate one of the plurality of images thereby to create at least a portion of an imposed flat.

Additionally, in accordance with an embodiment of the present invention, the plurality of images are defined in a first page description language and the imposition windows and the flat template are defined in a second page description language. The second page description language is preferably the POSTSCRIPT page description language.

Moreover, in accordance with an embodiment of the present invention, the apparatus of the present invention includes apparatus for interpreting the flat template to derive flat organization information therefrom.

Further, in accordance with an embodiment of the present invention, the apparatus for receiving a plurality of images, the apparatus for defining and the apparatus for replacing are part of a color electronic prepress system. Preferably, the apparatus for receiving and generating is part of an impositioning system.

Still further, in accordance with an embodiment of the present invention, the apparatus of the present invention includes apparatus for exposing the imposed flat. The apparatus for exposing preferably includes apparatus for receiving information in the first page description language.

Additionally, in accordance with an embodiment of the present invention, the apparatus for interpreting includes apparatus for receiving the flat organization information and for controlling the apparatus for exposing therewith.

Moreover, in accordance with an embodiment of the present invention, the images can be selected from the group consisting of: images for labels, images for packaging. Alternatively or in addition, the plurality of images includes a plurality of the same image.

There is also provided, in accordance with an embodiment of the present invention, a method for electronic impositioning including the steps of a) receiving a plurality of images of pages to be printed each page occupying a corresponding printing rectangle of predetermined size, b) associating with each image an imposition window of the size of the corresponding printing rectangle, c) receiving a plurality of the imposition windows and generating at least a portion of a flat template therefrom and d) replacing each of the imposition windows with the appropriate one of the plurality of images thereby to create at least a portion of an imposed flat.

Additionally, in accordance with an embodiment of the present invention, the method of the present invention includes the step of interpreting the flat template to derive flat organization information therefrom.

Moreover, in accordance with an embodiment of the present invention, the steps of receiving a plurality of images, defining and replacing are performed on a color electronic prepress system. The step of receiving and generating is typically performed on an impositioning system.

Further, in accordance with an embodiment of the present invention, the method of the present invention includes the step of exposing the at least a portion of an imposed flat.

Still further, in accordance with an embodiment of the present invention, the step of exposing includes the step of receiving information in the first page description language.

Finally, in accordance with an embodiment of the present invention, the step of interpreting includes the step of receiving the flat organization information and using the flat organization information to control apparatus for exposing.

### BRIEF DESCRIPTION OF THE DRAWINGS AND ANNEX

The present invention will be understood and appreciated more fully from the following detailed description taken in conjunction with the drawings and annexes in which:
Fig. 1 is a block diagram illustration of a system for electronic stripping using a color electronic prepress system (CEPS) and an impositioning system, constructed and operative in accordance with a preferred embodiment of the present invention;
Fig. 2 is a pictorial illustration of a flat template, useful in understanding the operation of the system of Fig. 1;
Fig. 3 is a flow chart illustration of a method of extracting information from an imposed file, useful in the method of Fig. 1; and
Annex A is a specification of the format of an impositioning file and the format of expected output of the impositioning system, useful in the system of the present invention.

### DETAILED DESCRIPTION OF PRESENT INVENTION

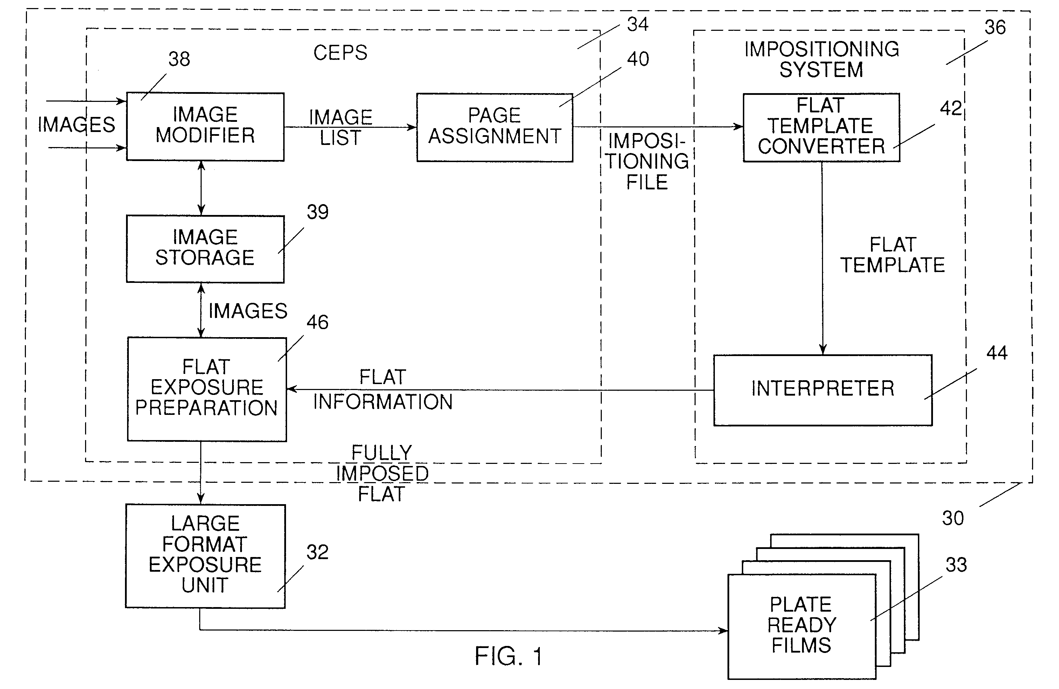

Reference is now made to Fig. 1 which illustrates a system 30 for electronic stripping, constructed and operative in accordance with a preferred embodiment of the present invention.

The system 30 typically receives a plurality of images of pages in a final document to be modified and to be organized in a desired page order and produces a fully imposed flat for exposure by a large format exposure unit 32, similar to prior art large format exposure units. The large format exposure unit 32 produces a plate ready film 33 from each fully imposed flat.

The system 30 comprises a CEPS 34, a slightly modified version of prior art CEPS, and an impositioning system 36, a slightly modified version of prior art impositioning workstations.

The CEPS 34 receives the images, typically described in its native page description language (PDL), referred to herein as the "first" page description language. If necessary, the CEPS 34 modifies the images, with an image modifier 38, in accordance with the desires of an operator. Image modifier 38 is typically an integral part of the CEPS 34 and therefore, will not be further described herein.

After modification, the images are stored in an image storage unit 39 forming part of the CEPS 34.

A list of the images of the pages is provided to a page assignment unit 40 for receiving from the operator his desired page order of the final document to be prepared. The page assignment unit 40 also prepares an impositioning file to be sent to the impositioning system 36.

The impositioning file is typically defined in the page description language of the impositioning system 36, referred to herein as the "second" page description language. POSTSCRIPT is one such second page description language.

The impositioning file comprises the names of the images and bounding windows of the expected printed sizes of the images, including bleed areas.

Thus, the "images" provided to the impositioning system 36 are simply empty windows the size of the printed sizes of the images. The actual images, which are in the first page description language, are not converted to the second page description language.

The impositioning file is provided to a flat template generator 42 of the impositioning system 36. The flat temp!ate generator 42 comprises impositioning software, such as IMPOSTRIP mentioned hereinabove, with some small modifications.

Since the "images" the flat template generator 42 receives are bounding windows rather than actual images, the impositioning software produces is a flat template, rather than a fully imposed flat. The flat template is defined in the second page description language. The flat template can be a full template or only a portion thereof.

It will be appreciated that, since the bounding windows are the same sizes for all color separations, the flat template generator 42 operates only once for a given large format page to be printed.

A specification of the impositioning file and of the format for describing certain elements of the flat template, described in detail hereinbelow, is provided herein in Annex A. The software in Annex A is written in the POSTSCRIPT language.

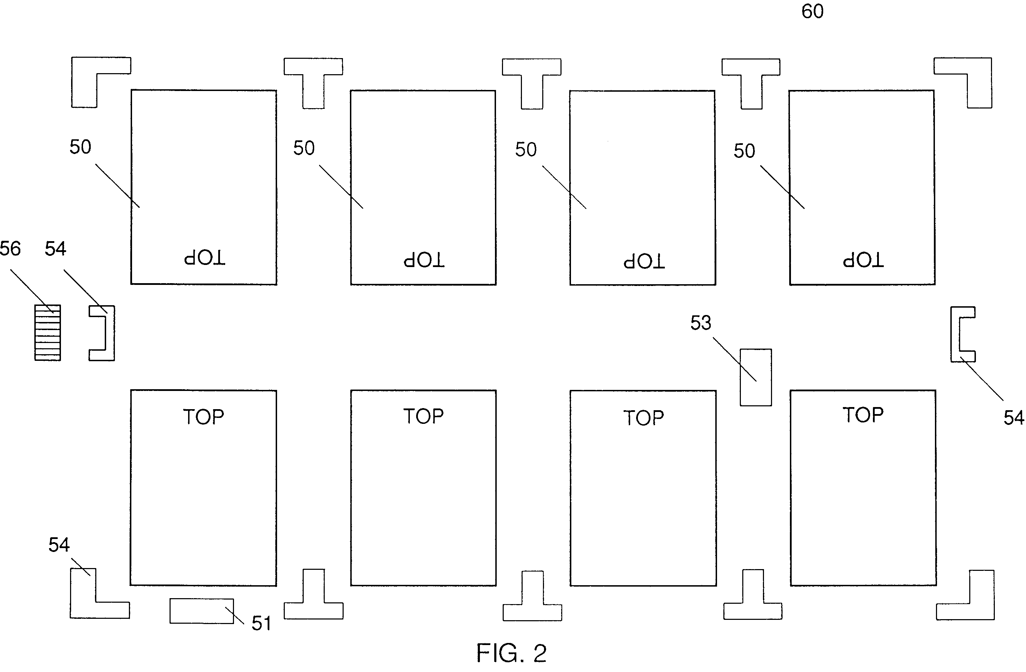

The flat template is illustrated in Fig. 2, to which reference is now briefly made. The flat template comprises a plurality of bounding windows 50 with a plurality of different marks 54 located around the edge of the template for marking the corners of the template and at least some of the corners of the bounding windows 50. The marks 54 can be utilized for registering each of the four plate ready films 33, one for each color separation, which produce a large format printed paper.

Typically, a color bar 56, a slug 51 and collating marks 53, are also included in the flat. As is known in the art, a slug is one or more lines of type used for identification and is always printed in the lower left hand corner of a flat. Collating marks 53 are small numbered rectangles used in bindery operations to check printed signatures for proper sequence and completeness. The collating marks 53 are placed between the lowest and highest numbered pages on the flat.

It can be seen that the bounding windows 50 are typically not centered on the paper but rather, a gripper area 60 is provided on one side of the flat.The gripper area 60 of the large format printed paper is the area that is gripped by the equipment of the printing press in order to place the paper on the press.

It can further be seen that the bounding windows 50 are oriented such that their tops generally face each other.

In accordance with a preferred embodiment of the present invention, named images of the marks 54, the collating marks 53 and the color bar 56 are stored in the image storage unit 39, wherein each orientation of each mark 54, collating mark 53 and color bar 56 has a different name.

The flat template is provided to a interpreter 44 (Fig. 1), such as a modified version of the Visionary Interpreter for Postscript manufactured by Scitex Corporation Ltd., for extracting organization information of the flat template, such as the positions and orientations of the images of the pages and the names and positions of the marks 54, collating marks 53 and color bar 56.

The interpreter 44 typically forms part of the impositioning system 36; however it can also form part of the CEPS 34.

The interpreter 44 reads the flat template file to find page description tokens in the formats described in Annex A under the headings page, mark, slug or collating mark alias format.

The tokens in these formats describe the names of the images associated with the bounding windows 50, the marks 54, the collating marks 53 and the color bars 56 to be placed on a given flat. It also interprets the file to ascertain the position and orientation of each image, the extent of clipping to be performed on each image, the position of the marks 54, collating marks 53 and the color bars 56, and the job information and location of the slug 51.

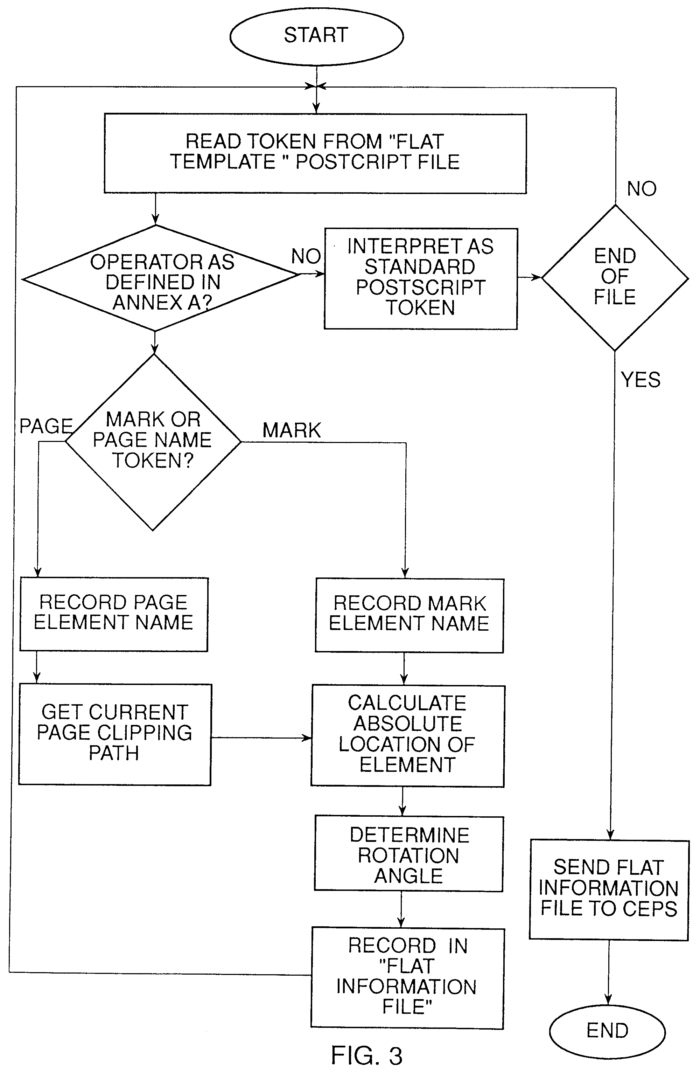

Fig. 3 details the method of operation of the interpreter 44. It is believed to be self-explanatory and therefore, in the interest of conciseness, will not be described herein.

The extracted information is then provided as commands to a flat exposure preparation unit 46, typically forming part of the CEPS 34, for creating a fully imposed flat. The flat exposure preparation unit 46 repeats the following process for each color separation of the plate ready films 33:
a) in accordance with the list of images in a given flat, the flat exposure preparation unit 46 accesses the image storage unit 39 for one separation of each of the entirety of images to be placed on the plate ready film 33 (for example, for producing the cyan plate ready film 33, the flat exposure preparation unit 46 retrieves the cyan separations of selected images);
b) in accordance with the list of marks 54, collating marks 53 and color bars 56, the flat exposure preparation unit 46 accesses the image storage unit 39 for the relevant separation of the images of the listed marks 54, collating marks 53 and color bars 56 (if the mark has no color, then only one "separation" of the image of the mark exists); and
c) in accordance with the extracted information, the flat exposure preparation unit 46 clips any of the retrieved separations, places them in their respective locations and their respective orientations and adds the job information in the slug 51 in its location, thereby producing at least a portion of a fully imposed flat file.

The flat exposure preparation unit 46 then sends the flat file to the exposure unit 32 for exposure.

It will be appreciated by persons skilled in the art that the present invention utilizes the impositioning system 36 to provide the placement information for each flat to be exposed but that each flat is actually produced by the CEPS 34. Effectively, the flat exposure preparation unit 46 "replaces" the bounding windows 50, the marks 54 and the color bar 56 of the flat template with the images of the pages, marks and color bar stored in the image storage unit 39.

It will be noted that the impositioning system 36 can reside on a stand-alone workstation, such as the MACINTOSH, as shown in Fig. 1, or it can reside within the CEPS 34.

It be appreciated that the above method of impositioning can be utilized with the entirety of impositioning operations which the impositioning system 36 performs. For example, current impositioning systems 36 prepare organize plate ready films 33 for printing labels and/or packaging texts. They also perform film saving calculations to ensure the minimal number of printing plates to produce a desired number of final documents.

It will further be appreciated by persons skilled in the art that the present invention is not limited to what has been particularly shown and described hereinabove. Rather the scope of the present invention is defined only by the claims which follow:

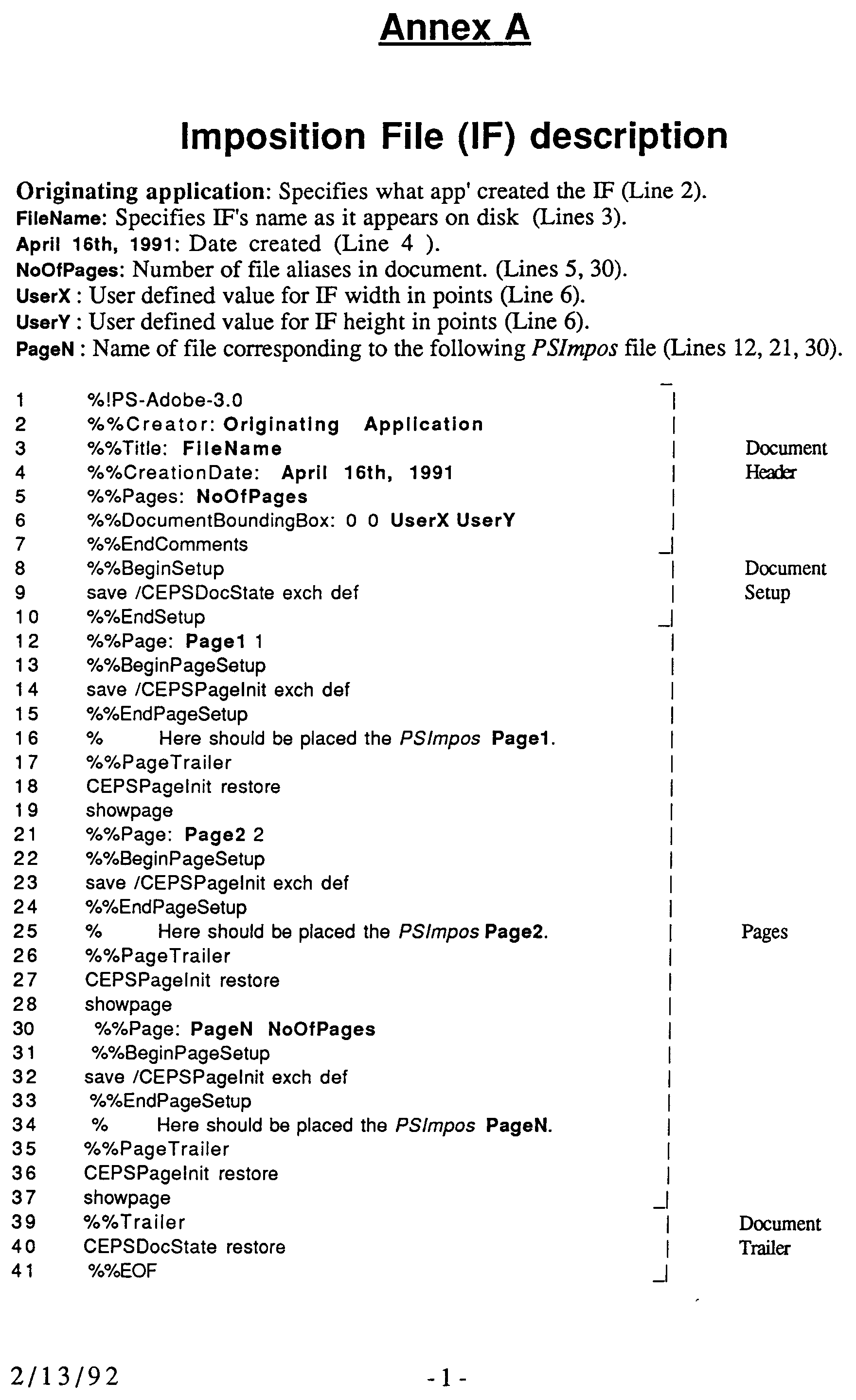

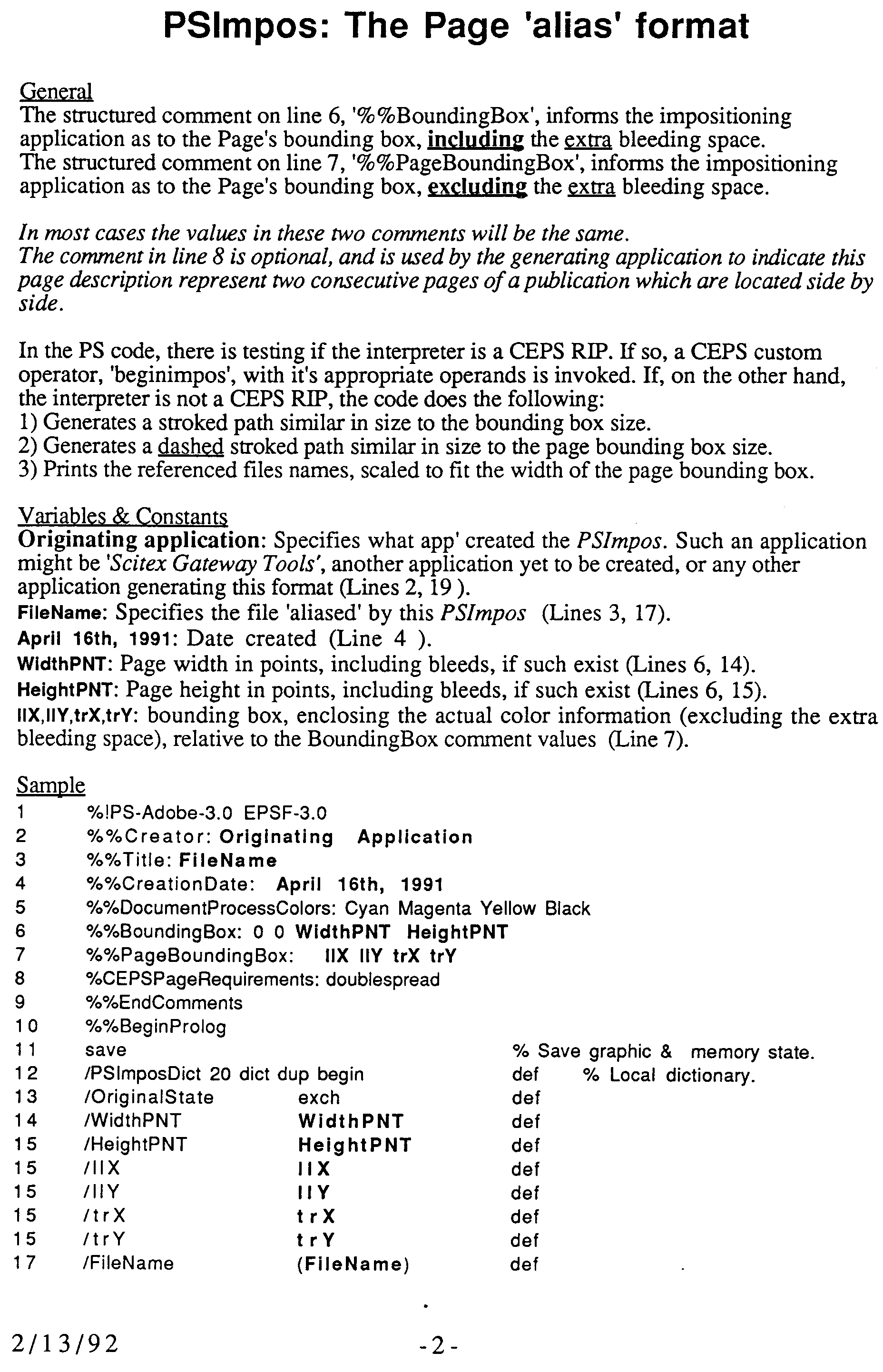

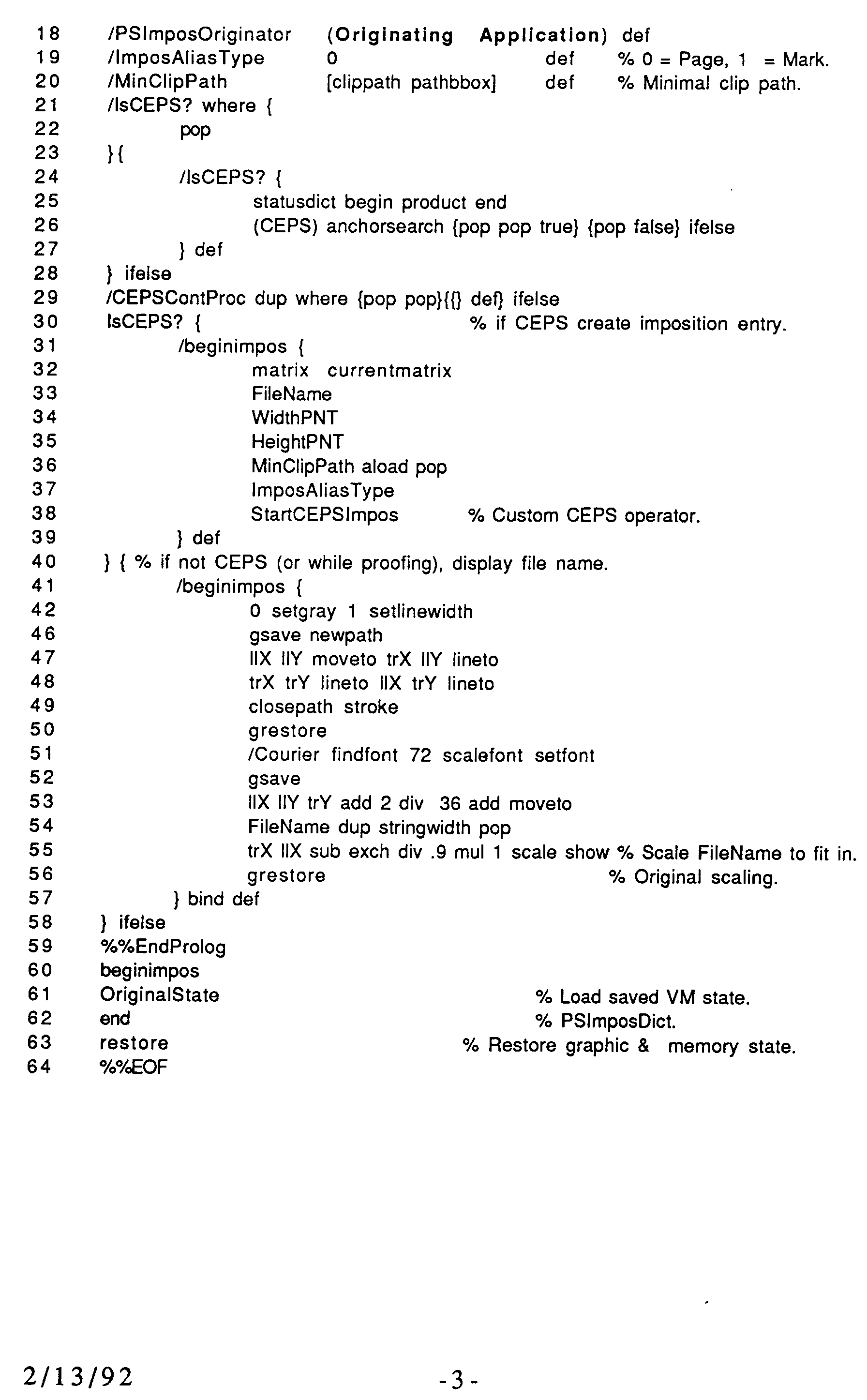

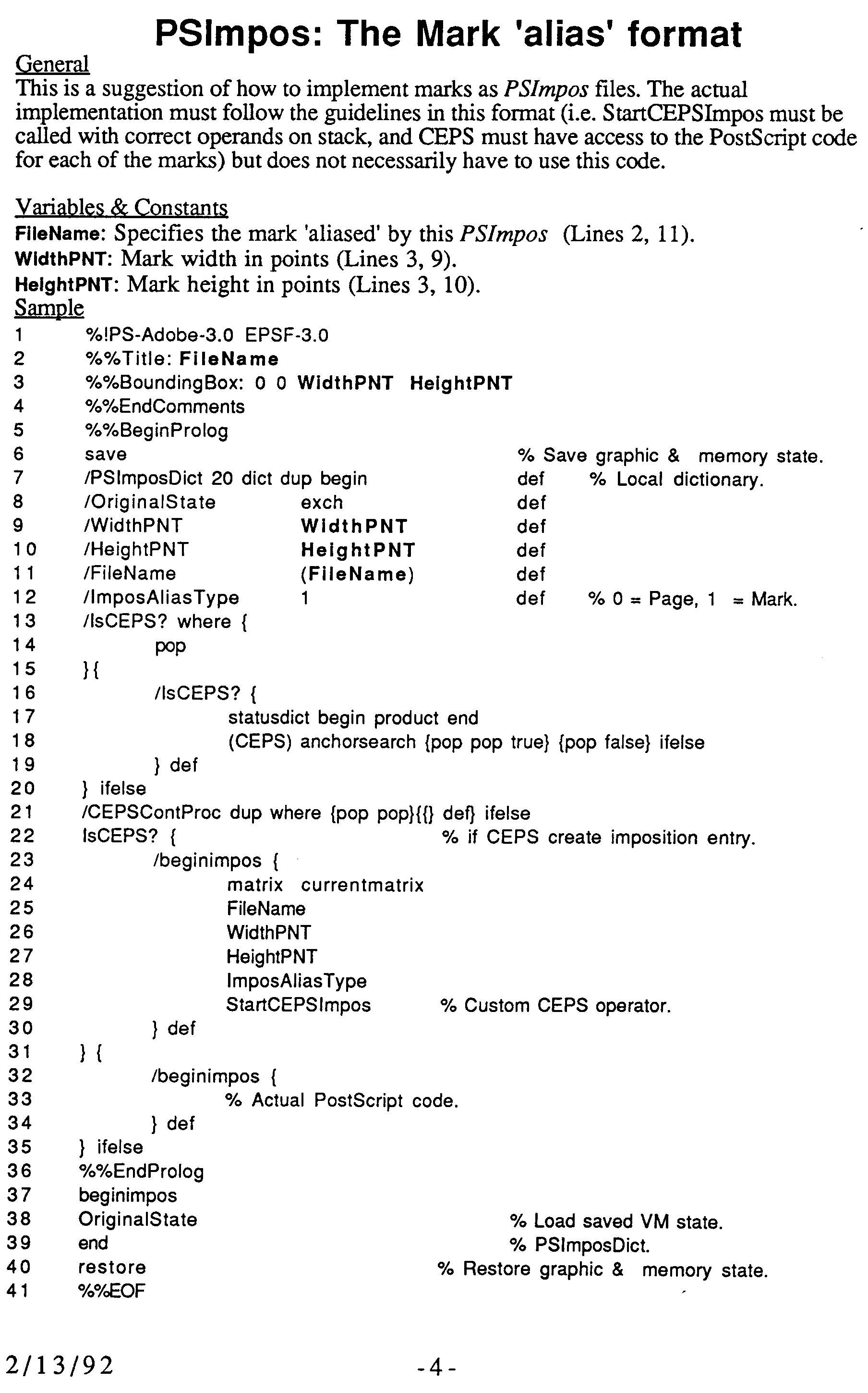

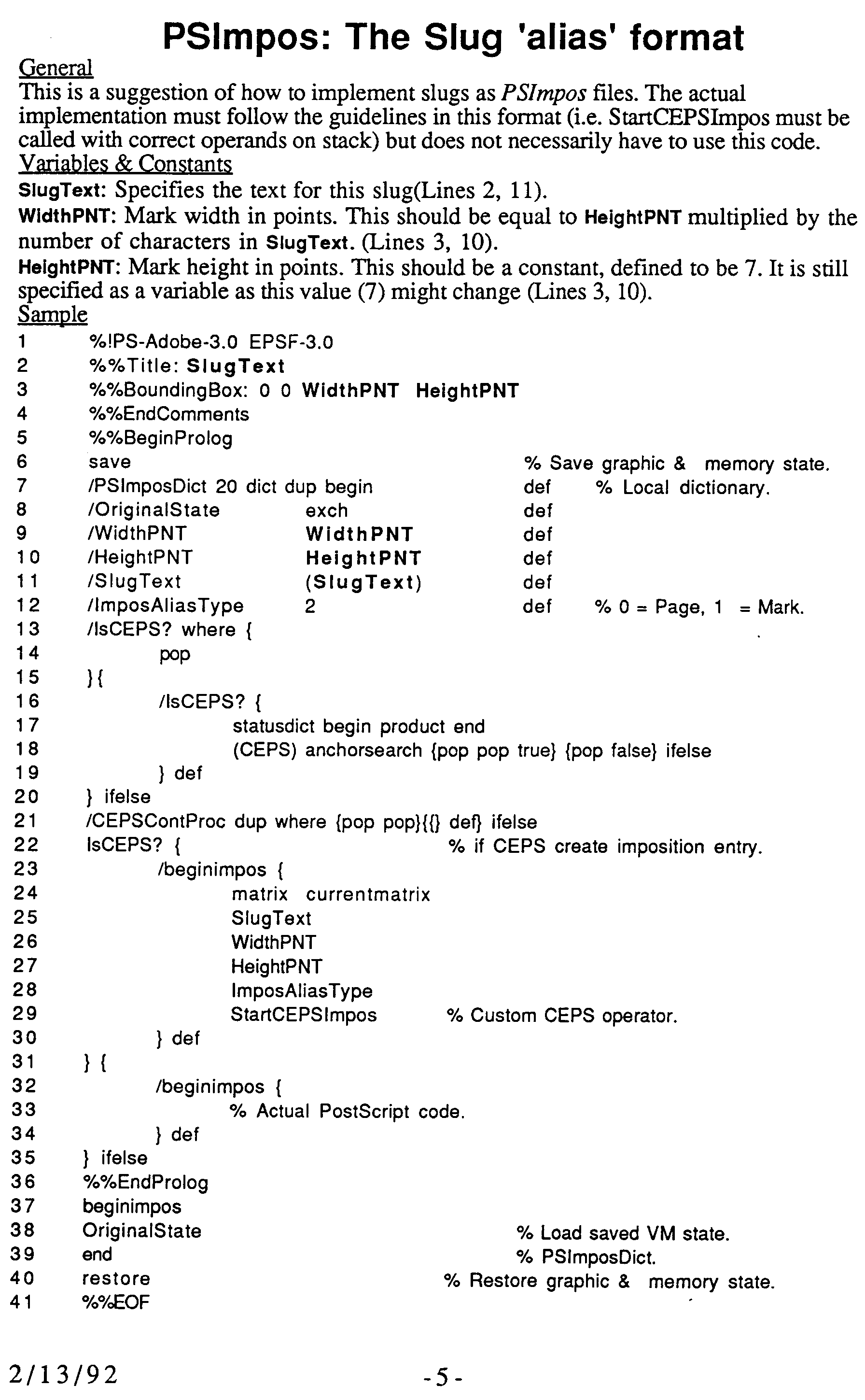

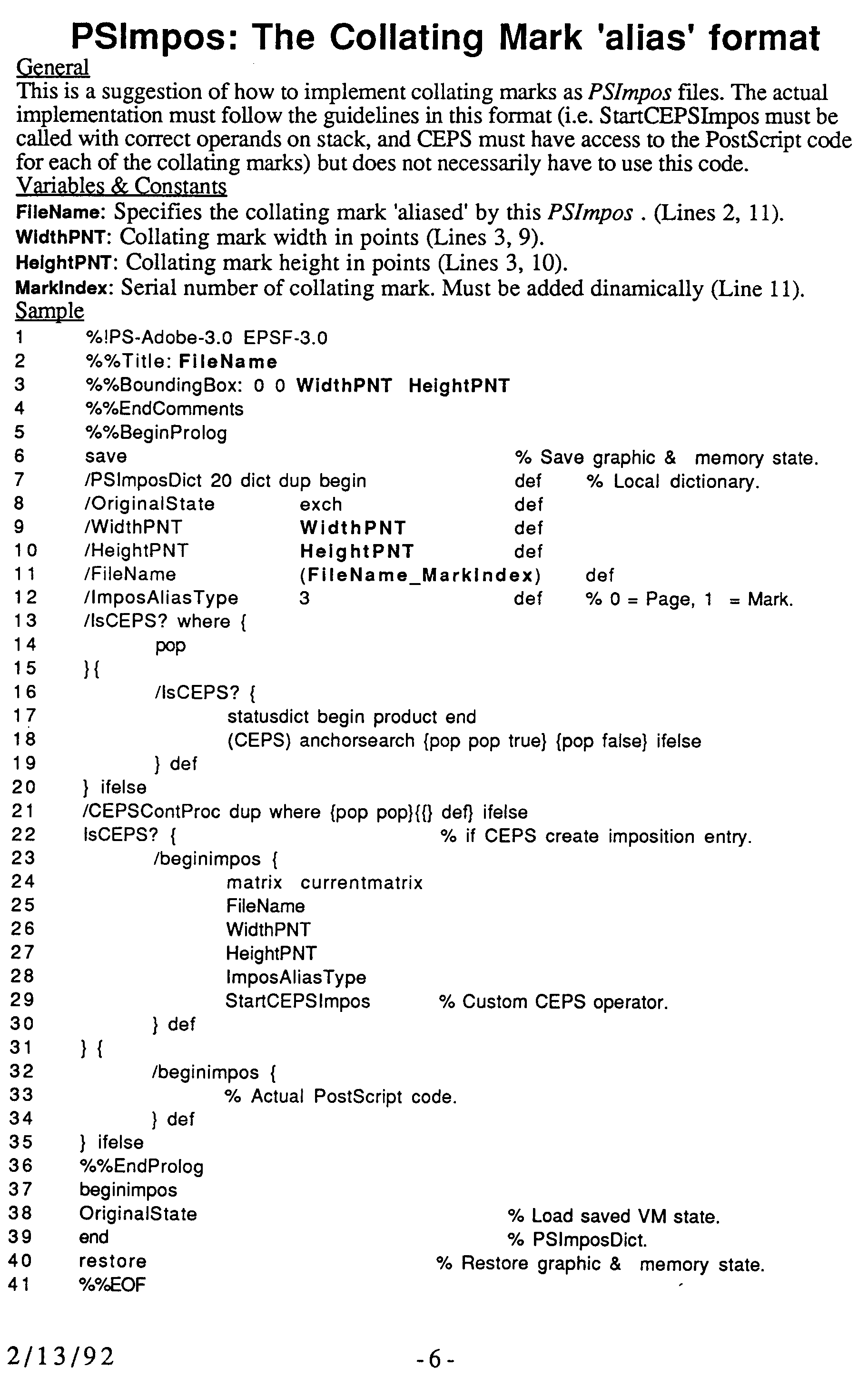

## Claims

1. Apparatus for electronic impositioning comprising:
means for receiving a plurality of images of pages to be printed each image occupying a corresponding printing rectangle of predetermined size;
means for associating with each image an imposition window of the size of said corresponding printing rectangle;
means for receiving a plurality of said imposition windows and for generating at least a portion of a flat template therefrom; and
means for replacing each of said imposition windows with the appropriate one of said plurality of images thereby to create at least a portion of an imposed flat.

2. Apparatus according to claim 1 wherein said plurality of images are defined in a first page description language and wherein said imposition windows and said flat template are defined in a second page description language.

3. Apparatus according to claim 1 and wherein said second page description language is the POSTSCRIPT page description language.

4. Apparatus according to claim 2 and including means for interpreting said flat template to derive flat organization information therefrom.

5. Apparatus according to any of the previous claims and wherein said means for receiving a plurality of images, said means for defining and said means for replacing are part of a color electronic prepress system.

6. Apparatus according to claim 5 and wherein said means for receiving and generating is part of an impositioning system.

7. Apparatus according to claim 1 forming part of a color electronic prepress system.

8. Apparatus according to any of the previous claims and including means for exposing said at least a portion of an imposed flat.

9. Apparatus according to claims 2 and 8 wherein said means for exposing includes means for receiving information in said first page description language.

10. Apparatus according to claims 4 and 8 and wherein said means for interpreting include means for receiving said flat organization information and for controlling said means for exposing therewith.

11. Apparatus according to any of the previous claims and wherein said images can be selected from the group consisting of: images for labels, images for packaging.

12. Apparatus according to any of the previous claims and wherein said plurality of images comprises a plurality of the same image.

13. A method for electronic impositioning comprising the steps of:
receiving a plurality of images of pages to be printed each image occupying a corresponding printing rectangle of predetermined size;
associating with each image an imposition window of the size of said corresponding printing rectangle;
receiving a plurality of said imposition windows and generating at least a portion of a flat template therefrom; and
replacing each of said imposition windows with the appropriate one of said plurality of images thereby to create at least a portion of an imposed flat.

14. A method according to claim 13 wherein said plurality of images are defined in a first page description language and wherein said imposition windows and said flat template are defined in a second page description language.

15. A method according to claim 13 and wherein said second page description language is the POSTSCRIPT page description language.

16. A method according to claim 14 and including the step of interpreting said flat template to derive flat organization information therefrom.

17. A method according to any of claims 13 - 16 and wherein said steps of receiving a plurality of images, defining and replacing are performed on a color electronic prepress system.

18. A method according to claim 17 and wherein said step of receiving and generating is performed on an impositioning system.

19. A method according to any of claims 13 - 18 and including the step of exposing said at least a portion of an imposed flat.

20. A method according to claims 14 and 19 wherein said step of exposing includes the step of receiving information in said first page description language.

21. A method according to claim 16 and wherein said step of interpreting includes the step of receiving said flat organization information and using said flat organization information to control a means for exposing.

22. A method according to any claims 13 - 21 and wherein said images can be selected from the group consisting of: images for labels, images for packaging.

23. A method according to any of claims 13 - 22 and wherein said plurality of images comprises a plurality of the same image.
